# EUROPÄISCHE PATENTSCHRIFT

(11) **EP 2 203 945 B1**
(45) Veröffentlichungstag und Bekanntmachung des Hinweises auf die Patenterteilung: **16.04.2014**
(21) Anmeldenummer: 08841820.7
(22) Anmeldetag: 24.10.2008
(51) Int. Cl.: H01L 51/00, H01L 51/54, H01L 51/46, H01L 51/44, H01L 51/50, H01L 51/52

(54) **OPTOELEKTRONISCHE VORRICHTUNG**
OPTOELECTRONIC DEVICE
DISPOSITIF OPTOELECTRONIQUE

(30) Priorität: 24.10.2007 US 923522; 03.09.2008 DE 102008045662
(43) Veröffentlichungstag der Anmeldung: 07.07.2010
(73) Patentinhaber: Merck Patent GmbH, 64293 Darmstadt (DE)
(72) Erfinder: BUCHHOLZ, Herwig, 60599 Frankfurt (DE); HEUN, Susanne, 65812 Bad Soden (DE)
(86) Internationale Anmeldenummer: PCT/EP2008/009020
(87) Internationale Veröffentlichungsnummer: WO 2009/053088

(56) Entgegenhaltungen:
- EP-A- 1 339 112
- EP-A- 1 647 566
- EP-A- 1 811 533
- US-A1- 2005 037 236
- US-A1- 2005 162 075
- US-A1- 2005 176 230
- US-A1- 2007 126 347

## Beschreibung

Die vorliegende Erfindung betrifft eine optoelektronische Vorrichtung, umfassend auf einem Substrat eine erste Schicht, eine zweite Schicht und mindestens eine zusätzliche Schicht, dadurch gekennzeichnet, dass die erste Schicht eine Indium-Zinnoxid-Schicht (ITO) oder eine Indium-Zinkoxid-Schicht (IZO) mit fluorhaltigen Gruppen ist, dass die zweite Schicht eine Schicht eines leitfähigen Polymers mit fluorhaltigen Gruppen umfasst und dass die zusätzliche Schicht Verbindungen mit fluorhaltigen Gruppen umfasst. Die Erfindung betrifft ferner die Verwendung der optoelektronischen Vorrichtung.

Elektronische Vorrichtungen, welche organische, metallorganische und/oder polymere Halbleiter enthalten, werden immer häufiger in kommerziellen Produkten verwendet oder stehen kurz vor der Markteinführung. Als Beispiele seien hier Ladungstransportmaterialien auf organischer Basis (beispielsweise Lochtransporter auf Triarylamin-Basis) in Kopiergeräten und organische oder polymere Leuchtdioden (OLEDs oder PLEDs) in Anzeige- und Displayvorrichtungen oder organische Photorezeptoren in Kopierern genannt. Organische Solarzellen (O-SC), organische Feldeffekt-Transistoren (O-FET), organische Dünnfilm-Transistoren (O-TFT), organische Schaltelemente (O-IC), organische optische Verstärker und organische Laserdioden (O-Laser) sind in einem fortgeschrittenem Entwicklungsstand und können in der Zukunft große Bedeutung erlangen.

Viele dieser elektronischen bzw. opto-elektronischen Vorrichtungen weisen unabhängig von dem jeweiligen Verwendungszweck folgenden allgemeinen Schichtaufbau auf, der für die jeweilige Anwendung angepasst werden kann:
(1) Substrat,
(2) Elektrode, die häufig metallisch oder anorganisch, aber auch aus organischen bzw. polymeren leitfähigen Materialien aufgebaut sein kann,
(3) gegebenenfalls eine oder mehrere Ladungsinjektionsschicht/en bzw. Pufferschicht/en zum Ausgleich von Unebenheiten der Elektrode, die häufig aus einem oder mehreren leitfähigen, dotierten Polymer/en ausgebildet ist/sind,
(4) mindestens eine Schicht eines organischen Halbleiters,
(5) gegebenenfalls eine oder mehrere weitere Ladungstransport- bzw. Ladungsinjektions- bzw. Ladungsblockierschicht/en,
(6) Gegenelektrode, bei der die unter (2) genannten Materialien eingesetzt werden,
(7) Verkapselung.

Die vorliegende Erfindung ist insbesondere, aber nicht ausschließlich, auf organische Leuchtdioden (OLED = Organic Light Emitting Diode) gerichtet, die bei Verwendung von polymeren Materialien oft auch als polymere Leuchtdioden (PLED = Polymer Light Emitting Diode) bezeichnet werden. Die obige Anordnung stellt den allgemeinen Aufbau einer optoelektronischen Vorrichtung dar, wobei verschiedene Schichten zusammengefasst werden können, so dass im einfachsten Fall eine Anordnung aus zwei Elektroden, zwischen denen sich eine organische Schicht befindet, besteht. Die organische Halbleiter-Schicht erfüllt in diesem Fall alle Funktionen, einschließlich der Emission von Licht. Ein derartiges System ist beispielsweise in der WO 9013148 A1 auf der Basis von Poly-(p-phenylenen) beschrieben.

Ein Problem, das sich in einem derartigen "Dreischichtsystem" ergibt, ist jedoch die fehlende Steuerung der Ladungstrennung oder die fehlende Möglichkeit, die einzelnen Bestandteile in unterschiedliche Schichten bezüglich ihrer Eigenschaften zu optimieren, wie es beispielsweise bei SMOLEDs ("small-molecule OLEDs") durch einen mehrschichtigen Aufbau einfach gelöst ist. Eine "small molecule OLED" besteht beispielsweise aus einer oder mehreren organischen Lochinjektionsschichten, Lochtransportschichten, Emissionsschichten, Elektronentransportschichten und Elektroneninjektionsschichten sowie einer Anode und einer Kathode, wobei sich das ganze System gewöhnlich auf einem Glassubstrat befindet. Ein Vorteil einer solchen Mehrlagenstruktur besteht darin, dass verschiedene Funktionen der Ladungsinjektion, des Ladungstransports und der Emission in die verschiedenen Schichten aufgeteilt und somit die Eigenschaften der jeweiligen Schichten separat modifiziert werden können.

Typische Lochtransportmaterialien in SMOLEDs sind beispielsweise Di-und Triarylamine, Thiophene, Furane oder Carbazole, wie sie auch in Photoleiteranwendungen untersucht und verwendet werden.

Metallchelate, konjugierte aromatische Kohlenwasserstoffe, Oxadiazole, Imidazole, Triazine, Pyrimidine, Pyrazine, Pyridazine, Phenanthroline, Ketone oder Phosphinoxide werden gewöhnlich für die Emissions- und Elektronentransport-Schichten in SMOLEDs verwendet.

Die Verbindungen, welche in einer SMOLED verwendet werden, können häufig durch Sublimationen gereinigt werden und stehen somit in Reinheiten größer als 99 Prozent zur Verfügung.

Das Aufbringen der Schichten in SMOLED-Vorrichtungen erfolgt gewöhnlich durch Aufdampfen in einer Vakuumkammer. Dieses Verfahren ist jedoch aufwändig und somit teuer und insbesondere für große Moleküle, wie beispielsweise Polymere, ungeeignet.

Polymere OLED-Materialien werden deshalb meist durch Beschichtung aus Lösung aufgetragen. Die Herstellung einer mehrschichtigen organischen Struktur durch Beschichtung aus Lösung erfordert jedoch, dass das Lösungsmittel mit der jeweils vorhergehenden Schicht inkompatibel ist, um diese nicht wieder anzulösen, zu quellen oder gar zu zerstören. Die Wahl des Lösungsmittels erweist sich jedoch als schwierig, da die eingesetzten organischen Verbindungen gewöhnlich ähnliche Eigenschaften, insbesondere ähnliche Lösungseigenschaften, besitzen. Bereits die Aufbringung einer ersten Polymerschicht auf beispielsweise eine Indium-Zinnoxid-Schicht bereitet meist schon Probleme, da keine ausreichende Haftung der Polymerschicht auf dem ITO gewährleistet werden kann. Darum werden ITO-Substrate gewöhnlich aufwendig gereinigt und mit einem UV/Ozon-Plasma oberflächenaktiviert, um eine bessere Haftung und einen besseren Kontrakt mit den nachfolgenden organischen Schichten zu gewährleisten. Die erste aufgebrachte-organische Schicht ist dabei gewöhnlich die sogenannte Pufferschicht, die aus einer wässrigen Dispersion (z.B. Clevios P Al 4083 von H. C. Starck) abgeschieden wird. Die erhaltene Schicht von PEDOT/PSS gleicht Unebenheiten der ITO-Schicht aus und sorgt für gute Lochinjektion in die nachfolgenden organischen Schichten. Ohne die Vorbehandlung des ITO würde die PEDOT-Schicht jedoch nicht haften, die direkte Abscheidung weniger polarer organischer Schichten auf ITO aus Lösung ist gar nicht möglich. Bei einer Aufbringung weiterer Schichten aus Lösung wird die erste Polymerschicht auf dem ITO wieder angelöst oder gar abgewaschen und dadurch zerstört.

Entsprechend sind polymere OLEDs nach dem Stand der Technik gewöhnlich auf der Anodenseite nur aus einer einschichtigen oder höchstens zweischichtigen organischen Struktur aufgebaut, wobei auf das PEDOT entweder direkt das emittierende Polymer folgt oder eine für die Lochinjektion und den Lochtransport verwendete Zwischenschicht. Vorteilhaft bei den polymeren OLEDs wäre jedoch auch eine Mehrschichtstruktur wie bei den SMOLEDs, wobei im Stand der Technik verschiedene Ansätze versucht wurden.

So offenbart beispielsweise die EP 0 637 899 A1 eine elektrolumineszierende Anordnung, enthaltend eine oder mehrere organische Schichten, wobei eine oder mehrere der Schichten durch thermische oder strahlungsindizierte Vernetzung erhalten werden. Ein Problem bei der thermischen Vernetzung ist, dass die polymeren Schichten einer relativ hohen Temperatur ausgesetzt werden, was zum Teil wieder zur Zerstörung der entsprechenden Schicht oder zur Bildung unerwünschter Nebenprodukte führt. Bei der Vernetzung mit aktinischer Strahlung sind häufig Moleküle oder Molekülteile notwendig, die eine radikalische, kationische oder anionische Polymerisation auslösen können. Es ist im Stand der Technik jedoch bekannt, dass solche Moleküle oder Molekülteile negative Einflüsse auf die Funktion einer optoelektronischen Vorrichtung haben können. Auch ist die Verwendung der energiereichen aktinischen Strahlung problematisch.

Es ist im Stand der Technik jedoch bekannt, dass solche Moleküle oder Molekülteile negative Einflüsse auf die Funktion einer optoelektronischen Vorrichtung haben können. Auch ist die Verwendung der energiereichen aktinischen Strahlung problematisch.

In der EP 1 811 533 A2 wird eine optoelektronische Vorrichtung offenbart, umfassend auf einem Substrat eine erste Schicht und eine zweite Schicht, wobei die erste Schicht ein Elektrodenmaterial mit fluorhaltigen Gruppen und die zweite Schicht ein Polymer mit fluorhaltigen Gruppen umfasst.

In der EP 1 647 566 A2 wird eine optoelektronische Vorrichtung offenbart, umfassend auf einem Substrat eine erste Schicht und eine zweite Schicht, die dadurch gekennzeichnet ist, dass die zweite Schicht fluorhaltige Gruppen umfasst.

Die Aufgabe der vorliegenden Erfindung bestand somit in der Bereitstellung einer optoelektronischen Vorrichtung, die mehrere spezialisierte funktionale Schichten umfasst, die aus Lösung oder Dispersion abgeschieden werden können, jeweils gut aufeinander haften, d.h. einen guten Kontakt gewährleisten, und sich durch einen nachfolgenden Coatingschritt auch nicht wieder ablösen lassen.

Die Aufgabe wird gelöst durch eine optoelektronische Vorrichtung, umfassend auf einem Substrat eine erste Schicht, eine zweite Schicht und mindestens eine zusätzliche Schicht, dadurch gekennzeichnet, dass die erste Schicht eine Indium-Zinnoxid-Schicht (ITO) oder eine Indium-Zinkoxid-Schicht (IZO) mit fluorhaltigen Gruppen ist, dass die zweite Schicht eine Schicht eines leitfähigen Polymers mit fluorhaltigen Gruppen umfasst und dass die zusätzliche Schicht Verbindungen mit fluorhaltigen Gruppen umfasst, wobei zwischen einem Teil der fluorhaltigen Gruppen der ersten Schicht und der zweiten Schicht und zwischen einem Teil der fluorhaltigen Gruppen der zweiten Schicht und der zusätzlichen Schicht eine adhäsive Fluor-Fluor-Wechselwirkung besteht.

Die zusätzliche Schicht kann ein

Polymer mit fluorierten Gruppen, ein teilweise fluoriertes Polymer oder ein Polymer mit fluorierten oder perfluorierten Seitengruppen, ein Oligomer mit fluorierten Gruppen oder ein fluoriertes Molekül umfassen. Dadurch besteht zwischen einem Teil der fluorhaltigen Gruppen der Komponenten der zusätzlichen Schicht und der jeweiligen vorhergehenden Schicht eine adhäsive Fluor-Fluor-Wechselwirkung.

Die zusätzliche Schicht ist bevorzugt eine Ladungsinjektionsschicht, eine Emitterschicht, eine Barriereschicht und/oder eine Kombination der genannten.

In einer weiteren bevorzugten Ausführungsform der Erfindung ist es bevorzugt, dass das Polymer der weiteren Schicht mindestens eine Emitterfunktion aufweist. Insbesondere soll das Polymer mit Emitterfunktion Licht verschiedener Wellenlängen emittieren. Dies kann dadurch erreicht werden, dass in der Schicht unterschiedliche Emitter in einem oder in mehreren Polymeren oder einem Blend vorliegen.

Darüber hinaus ist es bevorzugt, dass die Vorrichtung mehrere Schichten von Polymeren mit Emitterfunktion umfasst. Besonders bevorzugt ist dabei, dass die mehreren Schichten der Polymere mit Emitterfunktion jeweils Licht verschiedener Wellenlängen emittieren.

In einer besonders bevorzugten Ausführungsform ist es ferner bevorzugt, dass sich die verschiedenen Wellenlängen zur Farbe Weiß addieren.

Eine bevorzugte Ausführungsform der Erfindung umfasst beispielsweise eine Mehrschichtanordnung für einen Weißlichtemitter, umfassend eine Zwischenschicht und eine blaue Polymerschicht, welche beide über F-F-Wechselwirkungen adhärieren, und eine gelb emittierende Schicht, deren Kontakt ebenfalls durch Fluor-Fluor-Wechselwirkungen verstärkt werden kann. Der gelbe Triplett-Emitter kann ein echter gelber Emitter sein oder ein Emitter, welcher sich aus einem roten und grünen Emitter zusammensetzt. Durch den Einsatz von stabilen Triplett-Emittern mit hohen Effizienzen kann ein Weißlicht emittierendes System mit hoher Effizienz und hoher Lebensdauer erhalten werden. Dieses System zeichnet sich zudem durch eine einfache Herstellungsmethode (keine Vakuumaufdampfung erforderlich) und somit geringere Kosten aus.

In einer noch weiteren Ausführungsform der Erfindung kann die Vorrichtung mehrere Schichten von Polymeren mit Lochleiterfunktion umfassen, wobei die Lochleiter energetisch unterschiedliche höchste besetzte Molekülorbitale (HOMO) aufweisen.

Dabei ist es insbesondere bevorzugt, dass die zuletzt aufgebrachte Polymerschicht mit Lochleiterfunktion ein energetisch hohes niedrigstes unbesetztes Molekülorbital (LUMO) aufweist. Auf diese Weise ist die zuletzt aufgebrachte Polymerschicht eine Elektronenblockierschicht.

In einer noch weiteren Ausführungsform der Erfindung kann die Vorrichtung mehrere Schichten von Polymeren mit Elektronenleiterfunktion umfassen, wobei die Elektronenleiter energetisch unterschiedliche niedrigste unbesetzte Molekülorbitale (LUMO) aufweisen.

Dabei ist es insbesondere bevorzugt, dass die zuerst aufgebrachte Polymerschicht mit Elektronenleiterfunktion ein energetisch niedriges höchstes besetztes Molekülorbital (HOMO) aufweist. Auf diese Weise ist die zuerst aufgebrachte Polymerschicht eine Lochblockierschicht.

Eine bevorzugte Ausführungsform umfasst somit eine Mehrschichtanordnung, umfassend mehrere (teil-)fluorierte polymere Lochleiter und/oder Elektronenleiter mit unterschiedlichen HOMO- und LUMO Energien und entsprechender Elektronen- bzw. Lochblockierfunktion. Dadurch kann eine verbesserte Loch- bzw. Elektroneninjektion aufgrund von abgestuften Barrierestufen erreicht werden und die Ladungsrekombination effizient in der Emissionsschicht gefangen werden. Die Funktionen von Ladungstransport und -blockierung werden dabei durch die gute Adhäsion der fluorierten Schichten untereinander und den daraus resultierenden guten Kontakt gestärkt.

Die erfindungsgemäße optoelektronische Vorrichtung umfasst ferner eine Kathode und vorzugsweise eine Verkapselung.

Erfindungsgemäß wird als Elektrode Indium-Zinnoxid (ITO) oder Indium-Zinkoxid (IZO) verwendet. In diesem Fall werden die fluorhaltigen Gruppen vorzugsweise nach dem Aufbringen der Elektrode auf das Substrat über eine Oberflächenreaktion oder CF₄-Plasmabehandlung auf die Elektrode aufgebracht.

Erfindungsgemäß ist die Verwendung einer Elektrode, die aus einer Kombination von ITO oder IZO mit einem leitfähigen Polymer besteht, wobei wiederum der Kontakt durch eine CF₄-Plasmabehandlung von ITO oder IZO und fluorhaltigen Gruppen im leitfähigen Polymer verstärkt wird.

Auf die aufgebrachte Schicht werden erfindungsgemäß eine oder mehrere zusätzliche Schichten aufgebracht. Die zusätzliche Schicht (bzw. die zusätzlichen Schichten) umfassen bevorzugt eine Ladungsinjektionsfunktion (Loch- oder Elektroneninjektionsfunktion), eine Emitterfunktion, eine Barrierefunktion oder Kombinationen der genannten Funktionen.

Erfindungsgemäß kann es ferner von Vorteil sein, dass die Vorrichtung eine Schicht (oder mehrere Schichten) mit kleinen Molekülen oder Oligomeren umfasst. Diese wird bevorzugt als letzte Schicht (vor einer Kathode) aufgebracht. Die Aufbringung der Schicht kann durch Beschichten aus Lösung, durch Druckverfahren, durch Aufdampfen oder sonstige im Stand der Technik bekannte Methoden erfolgen.

Im Sinne dieser Erfindung ist es bevorzugt, dass zwischen einem Teil der fluorhaltigen Gruppen der ersten Schicht und der jeweiligen weiteren Schichten eine adhäsive Fluor-Fluor-Wechselwirkung besteht.

Bevorzugt erfolgen ferner das Aufbringen einer Kathode und das Aufbringen einer Verkapselung an der optoelektronischen Vorrichtung.

"Ein Teil" der fluorhaltigen Gruppen bedeutet dabei, dass etwa 10 bis 100 %, bevorzugt 50 bis 100 % und besonders bevorzugt 90 bis 100 % der fluorhaltigen Gruppen in Wechselwirkung treten. Dabei kann beispielsweise der Abstand der Fluoratome, um miteinander in Wechselwirkung zu treten, in etwa dem Van-der-Waals Radius entsprechen. Zumindest ist der Abstand der Fluoratome zueinander so, dass eine attraktive F-F-Wechselwirkung eintritt, vergleichbar mit der Wechselwirkung bei Wasserstoffbrückenbindungen, In Bezug auf die Wechselwirkung der Schichten untereinander sollte die Zahl der Fluorgruppen der aus Lösung abgeschiedenen Schicht möglichst gut zum Fluorierungsgrad der bereits vorhandenen Oberfläche passen. Der Teil der wechselwirkenden Gruppen sollte dabei möglichst hoch sein, dass jede Fluor-tragende Gruppe der im 2. Schritt abgeschiedenen Schicht ein Pendant auf der zuvor abgeschiedenen (bzw. Plasma-modifizierten) Schicht findet. Bevorzugt umfasst ein Polymer in einer erfindungsgemäßen Schicht 0,5 bis 100 %, besonders bevorzugt 1 bis 50 % und insbesondere 1 bis 25 % fluorhaltige Gruppen, bezogen auf die Wiederholungseinheiten des Polymers. Hier bedeuten 100 %, dass jede Wiederholungseinheit des Polymers fluorhaltige Gruppen aufweist.

Im Sinne der vorliegenden Erfindung besitzen die fluorhaltigen Gruppen R_{f} bevorzugt die allgemeine Formel CₓH_{y}F_{z}, wobei x ≥ 0, y ≥ 0 und z ≥ 1 sind und keine, eine oder mehrere CH₂-Gruppen, die auch benachbart sein können, durch O, S, Se, Te, Si(R¹)₂, Ge(R¹)₂, NR¹, PR¹, CO, P(R¹)O ersetzt sein können, wobei R¹ bei jedem Auftreten gleich oder verschieden eine geradkettige, verzweigte oder cyclische Alkyl-, Alkenyl-, Alkinyl-, Aryl-, Arylalkyl-, Arylalkenyl-, Arylalkinyl-, Heteroaryl- oder Heteroalkylgruppe ist, wobei auch ein oder mehrere nicht benachbarte C-Atome der nicht aromatischen Anteile durch O, S, CO, COO oder OCO ersetzt sein können, mit der Maßgabe, dass zwei Reste R¹ auch miteinander Ringsysteme bilden können. Bevorzugte Gruppen umfassen beispielsweise F, CF₃, C₂F₅, CF₃(CH₂)ₐS, CF₃CF₂S oder (CF₃-(CH₂)ₐ)₂N, wobei a bevorzugt eine ganze Zahl von 0 bis 5 darstellt.

Überraschenderweise konnte gefunden werden, dass nach dem Aufbringen eines fluorierten Polymers oder eines Polymers mit fluorierten oder perfluorierten Seitengruppen aus Lösung auf fluorierte oder fluorhaltige Oberflächen nach dem Entfernen des Lösungsmittels sich das Polymer nicht mehr lösen, abwaschen oder wegschwemmen lässt und auch nicht quillt. Die Schicht konnte also ohne Anwendung von hohen Temperaturen und ohne Anwendung energiereicher Strahlung fixiert werden. Somit kann problemlos eine weitere Schicht aus Lösung aufgebracht werden, ohne die Struktur der vorhergehenden Schicht zu schädigen. Überraschenderweise wurde zudem gefunden, dass sich der gleiche Effekt bei der Aufbringung mehrerer fluorierter Polymere (oder fluorierter Oligomere oder fluorierter kleiner Moleküle) einstellt. Die Fluor-Fluor-Wechselwirkung der Schichten untereinander verursacht eine starke Adhäsion, was für einen besonders guten Kontakt zwischen den Schichten sorgt und somit mehrschichtige Vorrichtungen möglich macht, wie sie von den "small molecule OLEDs" bekannt sind.

Bevorzugte Materialien für das Substrat sind z. B. Gläser und Folien, die eine ausreichende mechanische Stabilität und Barrierewirkung gewährleisten.

Die erste Schicht befindet sich auf dem Substrat, und dient gewöhnlich als Elektrode. Erfindungsgemäß ist auf dem Substrat Indium-Zinnoxid (ITO) oder Indium-Zinkoxid (IZO) aufgebracht, was gewöhnlich durch Sputtern geschieht. Im Anschluss erfolgt die Fluorierung, beispielsweise durch eine CF₄-Plasmabehandlung.

In der zweiten Schicht befindet sich erfindungsgemäß ein leitfähiges Polymer. Ebenso ist es möglich, dass die zweite Schicht aus dem leitfähigen Polymer selbst besteht. Das leitfähige Polymer ist vorzugsweise ausgewählt aus PEDOT und PANI. Erfindungsgemäß ist das leitfähige Polymer ein Polymer, das fluorhaltige Gruppen trägt, beispielsweise fluoriertes PEDOT oder PANI. Bevorzugt ist das Polymer dotiert und kann somit als Ladungsinjektionsschicht fungieren. Bevorzugt ist das Polymer ein Polythiophenderivat, besonders bevorzugt Poly(3,4-ethylendioxy-2,5-thiophen) (PEDOT) oder Polyanilin (PANI). Bevorzugt werden die Polymere mit Polystyrolsulfonsäure oder anderen Polymer gebundenen Brönsted-Säuren dotiert und so in einen leitfähigen Zustand gebracht. Erfindungsgemäß weist das leitfähige Polymer bevorzugt fluorhaltige Gruppen R_{f} (beispielsweise wie oben definiert) auf.

PEDOT ist kommerziell erhältlich, beispielsweise von H.C. Stark. Meist liegt es mit Polystyrolsulfonsäure dotiert als PEDOT:PSS vor. PEDOT ist ein konjugiertes Polymer und kann positive Ladungen tragen. So wie PANI ist es ein transparentes Polymer und eignet sich deshalb hervorragend als Baustein in einer optoelektronischen Vorrichtung. Das Einbringen von fluorhaltigen Gruppen in PEDOT erfolgt vorteilhaft bei der Herstellung des Polymers, wobei fluorierte Monomere eingesetzt und entsprechend copolymerisiert werden können. Es ist ebenso möglich, fluorierte oder teilfluorierte Polystyrolsulfonsäure (bzw. deren Derivate und Copolymere) einzusetzen. Ebenso ist es möglich, wie auch bei PANI, eine aufgebrachte Polymerschicht beispielsweise durch CF₄-Plasmabehandlung zu fluorieren.

Polyanilin ist ein konjugiertes Polymer welches aus oxidativ und säurekatalysiert miteinander gekuppelten Anilin-Monomeren besteht. Polyanilin liegt direkt nach der Synthese dotiert vor (Emeraldine Salz, ES). Bei der säurekatalysierten Polymerisation ist das Dotiermittel das Säure-Anion, im basischen Milieu liegt die Basenform vor (Emeraldine Base, EB). Nicht dotiertes PANI erscheint blau, dotiertes PANI grün und die reduzierten Formen gelblich. Durch Dotieren mittels Einfügen oder Entfernen von Anionen mit unterschiedlichen chemisch-physikalischen Eigenschaften lassen sich gezielt Modifikationen einstellen.

Um ein erfindungsgemäß gewünschtes fluorhaltige Gruppen aufweisendes Polyanilin zu erhalten, kann Anilin zusammen mit Anilin-Derivaten copolymerisiert werden, z.B. indem Anilinmonomere mit Substituenten mit fluorhaltigen Resten R_{f} (beispielsweise wie oben definiert), z.B. 2-Trifluormethyl-Anilin oder ähnlichen Verbindungen, eingesetzt werden. Aber auch hier kann das Dotierungsmittel (PSS) die (teil-)fluorierten Gruppen tragen.

Grundsätzlich können im Sinne der Erfindung jedoch alle bekannten Pufferschichten eingesetzt und durch Einführung von Fluorgruppen modifiziert werden.

Erfindungsgemäß umfasst die erfindungsgemäße optoelektronische Vorrichtung eine zusätzliche Schicht. Bevorzugt ist, dass neben der einen zusätzlichen Schicht noch weitere zusätzliche Schichten in der Vorrichtung vorhanden sind. Im Sinne dieser Erfindung ist es, dass die zusätzliche Schicht (oder die zusätzlichen Schichten) Verbindungen mit fluorhaltigen Gruppen, vorzugsweise wie oben definiert, umfassen. Somit kann auch die wenigstens eine zusätzliche Schicht ein Polymer mit fluorhaltigen Gruppen, ein teilweise fluoriertes Polymer oder ein Polymer mit fluorierten oder perfluorierten Seitengruppen, ein Oligomer mit fluorierten Gruppen oder ein fluoriertes Molekül (kleines Molekül) sein.

Erfindungsgemäß zeichnet sich die optoelektronische Vorrichtung dadurch aus, dass zwischen einem Teil der fluorhaltigen Gruppen der zusätzlichen Schicht und der jeweiligen vorhergehenden Schicht eine adhäsive Fluor-Fluor-Wechselwirkung besteht. Im Sinne dieser Erfindung kann die zusätzliche Schicht eine Ladungsinjektionsschicht (Loch- oder Elektroneninjektionsschicht), eine Ladungstransportschicht (Loch- oder Elektronentransportschicht), eine Emitterschicht, eine Loch- oder Elektranenblockierschicht und/oder eine Kombination der genannten sein. Das heißt wiederum, dass die zusätzliche Schicht mehrere Funktionen in einer Schicht vereinen kann, bzw. dass mehrere zusätzliche Schichten die entsprechenden Funktionen übernehmen.

Dadurch ist erfindungsgemäß ein klassischer Aufbau aus Substrat, Elektrode, Multifunktionsschicht und Kathode oder ein Aufbau wie bei einem "small molecule OLED" möglich, nämlich ein Aufbau aus
1) Substrat,
2) Elektrode bzw. Anode,
3) Lochinjektionsschicht/en,
4) Lochtransportschicht/en,
5) Emissionsschicht/en
6) Elektronentransportschicht/en
7) Elektroneninjektionsschicht/en und
8) Gegenelektrode bzw. Kathode.

Erfindungsgemäß können eine oder mehrere der Schichten miteinander kombiniert werden oder es kann der Aufbau aus polymeren Schichten mit Schichten, wie sie aus einem SMOLED bekannt sind, kombiniert werden. Beispielsweise können Komponenten aufgedampft oder aufgedruckt werden, falls dies gewünscht ist, oder es können Komponenten aus Lösung aufgebracht werden, wobei die Komponenten bevorzugt fluorhaltige Gruppen aufweisen.

Die optoelektronische Vorrichtung im Sinne der vorliegenden Erfindung eignet sich als organische oder polymere Leuchtdiode, als organische Solarzelle (O-SC, z. B. WO 98/48433, WO 94/05045), als organischer Feldeffekt-Transistor (O-FETs), als organisches Schaltelement (O-IC, z. B. WO 95/31833, WO 99/10939), als organisches Feld-Quench-Element (FDQ, z. B. US 2004/017148), als organischer optischer Verstärker, als organischer Photorezeptor, als organische Photodiode oder als organische Laserdiode (O-LASER, z. B. WO 98/03566) und kann entsprechend dazu verwendet werden.

Für die Verwendung in O-FETs sind vor allem Materialien mit hoher Ladungsträgermobilität von Interesse. Dies sind beispielsweise Oligo- oder Poly(triarylamine), Oligo- oder Poly(thiophene) und Copolymere, die einen hohen Anteil dieser Einheiten enthalten.

Die Vorrichtung wird entsprechend (je nach Anwendung) strukturiert, kontaktiert und schließlich hermetisch versiegelt, da sich die Lebensdauer derartiger Vorrichtungen bei Anwesenheit von Wasser und/oder Luft drastisch verkürzt.

Für Anwendungen in O-FETs und O-TFTs ist es außerdem erforderlich, dass der Aufbau außer Elektrode und Gegenelektrode (source und drain) noch eine weitere Elektrode (gate) enthält, die durch eine Isolatorschicht mit einer in der Regel hohen (oder selten niedrigen) Dielektrizitätskonstante vom organischen Halbleiter abgetrennt ist. Außerdem kann es sinnvoll sein, in die Vorrichtung noch weitere Schichten einzubringen.

Die Elektroden werden im Sinne dieser Erfindung so gewählt, dass ihr Potential möglichst gut mit dem Potential der angrenzenden organischen Schicht übereinstimmt, um eine möglichst effiziente Elektronen- bzw. Lochinjektion zu gewährleisten.

Als Kathode sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lathanoide (z. B. Ca, Ba, Mg, Al, In, Mg, Yb, Sm, etc.). Bei mehrlagigen Strukturen können auch zusätzlich zu den genannten Metallen weitere Metalle verwendet werden, die eine relativ hohe Austrittsarbeit aufweisen, wie z. B. Ag, wobei dann in der Regel Kombinationen der Metalle, wie beispielsweise Ca/Ag oder Ba/Ag verwendet werden. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide in Frage (z. B. LiF, Li₂O, BaF₂, MgO, NaF, etc.). Die Schichtdicke dieser Schicht beträgt bevorzugt zwischen 1 und 10 nm. Als Anode sind Materialien mit hoher Austrittsarbeit bevorzugt. Bevorzugt weist die Anode ein Potential größer 4,5 eV vs. Vakuum auf. Für einige Anwendungen muss mindestens eine der Elektroden transparent sein, um entweder die Bestrahlung des organischen Materials (O-SC) oder die Auskopplung von Licht (OLED/PLED, O-LASER) zu ermöglichen. Ein bevorzugter Aufbau verwendet eine transparente Anode. Erfindungsgemäß sind Indium-Zinn-Oxid (ITO) oder Indium-Zink Oxid (IZO), welche fluorhaltige Gruppen aufweisen.

Als Lochinjektionsschicht auf der Anode kommen verschiedene dotierte, leitfähige Polymere in Frage. Bevorzugt sind Polymere, die je nach Anwendung eine Leitfähigkeit > 10⁻⁸ S/cm aufweisen, Das Potential der Schicht beträgt bevorzugt 4 bis 6 eV vs. Vakuum. Die Schichtdicke beträgt bevorzugt zwischen 10 und 500 nm, besonders bevorzugt zwischen 20 und 250 nm. Besonders bevorzugt werden Derivate von Polythiophen (insbesondere Poly(3,4-ethylendioxy-2,5-thiophen) (PEDOT) und Polyanilin (PANI) verwendet. Weitere bevorzugte (intrinsisch) leitfähige Polymere sind Polythiophen (PTh), Poly(3,4-ethylendioxythiophen) (PEDOT), Polydiacetylen, Polyacetalen (PAc), Polypyrrol (PPy), Polyisothianaphthen (PITN), Polyheteroarylenvinylen (PArV), wobei die Heteroarylen-Gruppe z.B. Thiophen, Furan oder Pyrrol sein kann, Poly-p-phenylen (PpP), Polyphenylensulfid (PPS), Polyperinaphthalin (PPN), Polyphthalocyanin (PPc) u.a., sowie deren Derivate (die z.B. aus mit Seitenketten oder -gruppen substituierten Monomeren gebildet werden), deren Copolymere und deren physikalische Mischungen. Die Dotierung erfolgt in der Regel durch Säuren oder durch Oxidationsmittel. Bevorzugt erfolgt die Dotierung durch Polymer gebundene Brönsted-Säuren. Besonders bevorzugt sind hierfür Polymer gebundene Sulfonsäuren, insbesondere Poly(styrolsulfonsäure), Poly(vinylsulfonsäure). Erfindungsgemäß weist das leitfähige Polymer für die Ladungsinjektionsschicht fluorhaltige Gruppen auf, wodurch nach dem Aufbringen aus Lösung und Entfernen des Lösungsmittels eine Fixierung der Schicht durch adhäsive F-F-Wechselwirkungen erfolgt.

Bevorzugt enthält das Polymer der Emitterschicht neben emittierenden Wiederholungseinheiten weitere Wiederholungseinheiten, die ebenfalls bevorzugt fluorhaltige Gruppen bzw. Substituenten aufweisen. Es kann sich dabei um eine einzige polymere Verbindung oder um einen Blend aus zwei oder mehr polymeren Verbindungen oder um einen Blend aus einer oder mehrerer polymerer Verbindungen mit einer oder mehreren niedermolekularen organischen Verbindungen handeln. Die organische Emitterschicht kann bevorzugt durch Beschichtung aus Lösung oder durch verschiedene Druckverfahren, insbesondere durch Tintenstrahldruckverfahren aufgebracht werden. Die polymere Verbindung und/oder die weiteren Verbindungen weisen erfindungsgemäß fluorhaltige Gruppen auf. Die Schichtdicke des organischen Halbleiters beträgt je nach Anwendung bevorzugt 10 bis 500 nm, besonders bevorzugt 20 bis 250 und insbesondere 30 bis 120 nm.

Bevorzugte Wiederholungseinheiten im Polymer der Emitterschicht sind, ohne darauf beschränkt zu sein, beispielsweise die im Folgenden gezeigten Verbindungen:

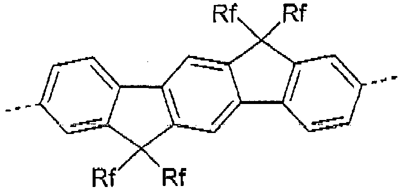

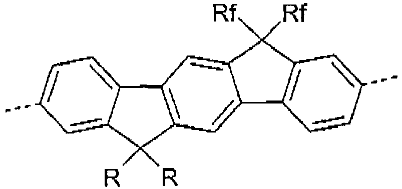

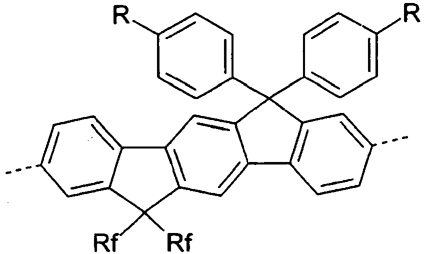

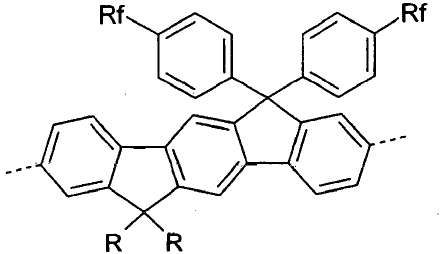

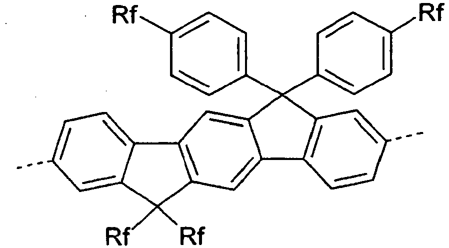

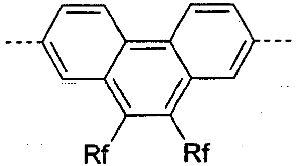

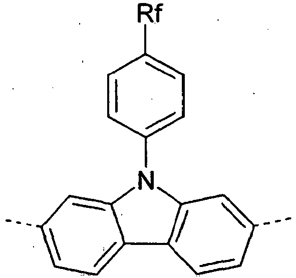

Dabei bedeutet Rf einen fluorierten Rest der allgemeinen Formel CₓH_{y}F_{z}, wobei x ≥ 0, y ≥ 0 und z ≥ 1 sind und keine, eine oder mehrere CH₂-Gruppen, die auch benachbart sein können, durch O, S, Se, Te, Si(R¹)₂, Ge(R¹)₂, NR¹, PR¹, CO, P(R¹)O ersetzt sein können, wobei R¹ sowie R bei jedem Auftreten gleich oder verschieden eine geradkettige, verzweigte oder cyclische Alkyl-, Alkenyl-, Alkinyl-, Aryl-, Arylalkyl-, Arylalkenyl-, Arylalkinyl-, Heteroaryl- oder Heteroalkylgruppe ist, wobei auch ein oder mehrere nicht benachbarte C-Atome der nicht aromatischen Anteile durch O, S, CO, COO oder OCO ersetzt sein können, mit der Maßgabe, dass zwei Reste R¹ auch miteinander Ringsysteme bilden können. Bevorzugte Gruppen umfassen beispielsweise F, CF₃, C₂F₅, CF₃(CH₂)ₐS, CF₃CF₂S oder (CF₃-(CH₂)ₐ)₂N, wobei a bevorzugt eine ganze Zahl von 0 bis 5 darstellt.

Bevorzugte Polymere bzw. fluorhaltige Polymere (oder Polymere mit fluorierten oder perfluorierten Seitengruppen) im Sinne dieser Erfindung sind konjugierte Polymere oder teilkonjugierte Polymere, die in der Hauptkette sp²-hybridisierte Kohlenstoffatome enthalten, die auch durch entsprechende Heteroatome ersetzt sein können. Des Weiteren wird im Sinne dieser Erfindung ebenfalls als konjugiert bezeichnet, wenn sich in der Hauptkette beispielsweise Arylamineinheiten und/oder bestimmte Heterocyclen (d. h. Konjugation über N-, O- oder S-Atome) und/oder metallorganische Komplexe (d. h. Konjugation über das Metallatom) befinden. Typische Vertreter konjugierter Polymere, wie sie beispielsweise in PLEDs oder allgemein in O-SCs verwendet werden können, sind Polypara-phenylenvinylene (PPV), Polyfluorene, Polyspirobifluorene, Polyphenanthrene, Polydihydrophenanthrene, Polyindenofluorene, Systeme, die im weitesten Sinne auf Poly-p-phenylenen (PPP) basieren, und Derivate dieser Strukturen, insbesondere solche Derivate, die fluorhaltige Gruppen aufweisen.

Besonders bevorzugt sind erfindungsgemäß solche Polymere, die weitere Strukturelemente enthalten und somit als Copolymere zu bezeichnen sind. Hier sei vor allem auch auf die relativ umfangreichen Auflistungen von möglichen Strukturelementen in der WO 02/077060, der WO 2005/014689 und die in diesen Schriften aufgeführten Zitate verwiesen. Diese weiteren Struktureinheiten können beispielsweise aus den im Folgenden beschriebenen Klassen stammen:
- Gruppe 1:: Struktureinheiten, welche das Polymer-Grundgerüst darstellen.
- Gruppe 2:: Struktureinheiten, welche die Lochinjektions- und/oder -transporteigenschaften der Polymere erhöhen.
- Gruppe 3:: Struktureinheiten, welche die Elektroneninjektions- und/oder -transporteigenschaften der Polymere erhöhen.
- Gruppe 4:: Struktureinheiten, die Kombinationen von Einzeleinheiten der Gruppe 2 und Gruppe 3 aufweisen.
- Gruppe 5:: Struktureinheiten, welche die Morphologie und/oder die Emissionsfarbe der resultierenden Polymere beeinflussen.
- Gruppe 6:: Struktureinheiten, welche die Emissionscharakteristik insoweit verändern, dass Elektrophosphoreszenz statt Elektrofluoreszenz erhalten werden kann.
- Gruppe 7:: Struktureinheiten, welche den Übergang vom Singulett- zum Triplettzustand verbessern.

Geeignete und bevorzugte Einheiten für die oben genannten Gruppen werden im Folgenden beschrieben, wobei diese bevorzugt die erfindungsgemäß definierten fluorhaltigen Gruppen aufweisen.

### Gruppe 1 - Struktureinheiten, welche das Polymer-Grundgerüst darstellen:

Bevorzugte Einheiten der Gruppe 1 sind insbesondere solche, die aromatische oder carbocyclische Strukturen mit 6 bis 40 C-Atomen beinhalten. Geeignete und bevorzugte Einheiten sind unter anderem Fluoren-Derivate, wie z.B. in der EP 0842208, der WO 99/54385, der WO 00/22027, der WO 00/22026 und der WO 00/46321 offenbart, Indenofluorene, ferner Spirobifluoren-Derivate, wie z.B. in der EP 0707020, der EP 0894107 und der WO 03/020790 offenbart, Phenanthren-Derivate oder Dihydrophenanthren-Derivate, wie z.B. in der WO 2005/014689 offenbart. Es ist auch möglich, eine Kombination von zwei oder mehr dieser Monomer-Einheiten zu verwenden, wie z.B. in der WO 02/077060 beschrieben. Bevorzugte Einheiten für das Polymergrundgerüst sind neben den Einheiten der Formel (1) insbesondere Spirobifluoren-, Indenofluoren-, Phenanthren- und Dihydrophenanthren-Derivate.

Besonders bevorzugte Einheiten der Gruppe 1 sind zweibindige Einheiten gemäß den folgenden Formeln, worin die gestrichelten Linien die Verknüpfungen zu den benachbarten Einheiten bedeuten: 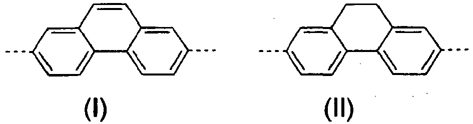 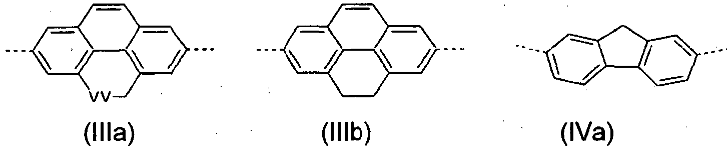 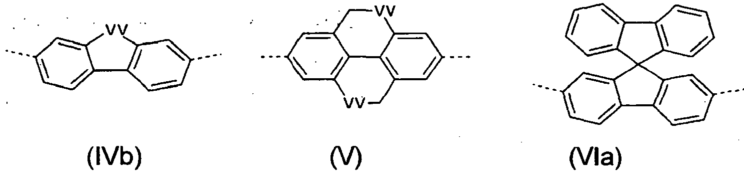 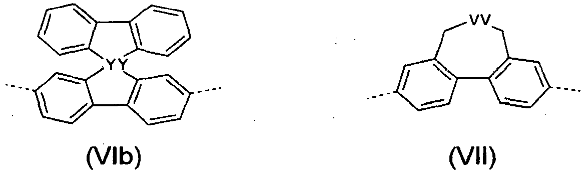 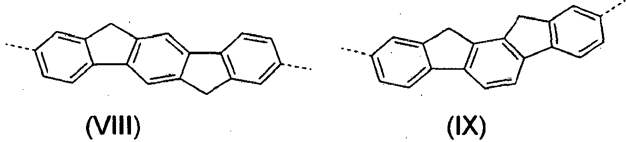 worin die einzelnen Reste folgende Bedeutung besitzen:
- YY: ist Si oder Ge,
- W: ist O, S oder Se,
und wobei die verschiedenen Formeln an den freien Positionen auch zusätzlich durch einen oder mehrere Substituenten R² substituiert sein können und R² folgendes bedeuten:
R² ist bei jedem Auftreten gleich oder verschieden H, eine geradkettige, verzweigte oder cyclische Alkyl- oder Alkoxykette mit 1 bis 22 C-Atomen, in der auch ein oder mehrere nicht benachbarte C-Atome durch O, S, CO, O-CO, CO-O oder O-CO-O ersetzt sein können, wobei auch ein oder mehrere H-Atome durch Fluor ersetzt sein können, eine Aryl- oder Aryloxygruppe mit 5 bis 40 C-Atomen, bei der auch ein oder mehrere C-Atome durch O, S oder N ersetzt sein können, welche auch durch ein oder mehrere nicht-aromatische Reste R² substituiert sein können, oder F, CN, N(R³)₂ oder B(R³)₂; und
R³ ist bei jedem Auftreten gleich oder verschieden H, eine geradkettige, verzweigte oder cyclische Alkylkette mit 1 bis 22 C-Atomen, in der auch ein oder mehrere nicht benachbarte C-Atome durch O, S, CO, O-CO, CO-O oder O-CO-O ersetzt sein können, wobei auch ein oder mehrere H-Atome durch Fluor ersetzt sein können, oder eine optional substituierte Arylgruppe mit 5 bis 40 C-Atomen, bei der auch ein oder mehrere C-Atome durch O, S oder N ersetzt sein können.

### Gruppe 2 - Struktureinheiten, welche die Lochinjektions- und/oder -transporteigenschaften der Polymere erhöhen:

Dies sind im Allgemeinen aromatische Amine oder elektronenreiche Heterocyclen, wie z.B. substituierte oder unsubstituierte Triarylamine, Benzidine, Tetraarylen-para-phenylendiamine, Phenothiazine, Phenoxazine, Dihydrophenazine, Thianthrene, Dibenzo-*p*-dioxine, Phenoxathiine, Carbazole, Azulene, Thiophene, Pyrrole, Furane und weitere O, S oder N-haltige Heterocyclen mit hoch liegendem HOMO (HOMO = höchst liegendes besetztes Molekülorbital). Es kommen hier aber auch Triarylphosphine in Frage, wie z.B. in der WO 2005/017065 A1 beschrieben.

Besonders bevorzugte Einheiten der Gruppe 2 sind zweibindige Einheiten gemäß den folgenden Formeln, worin die gestrichelten Linien die Verknüpfungen zu den benachbarten Einheiten bedeuten: 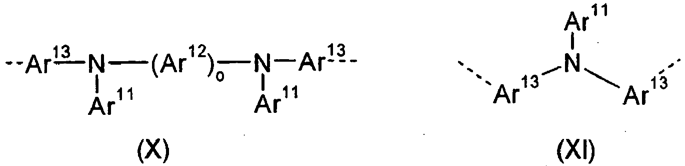 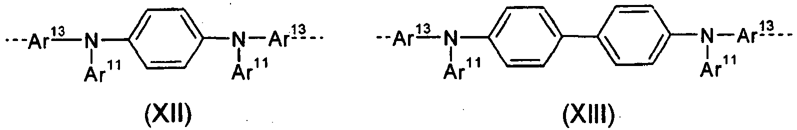 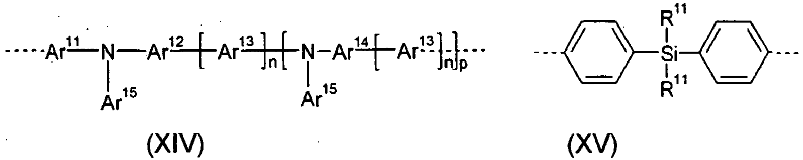 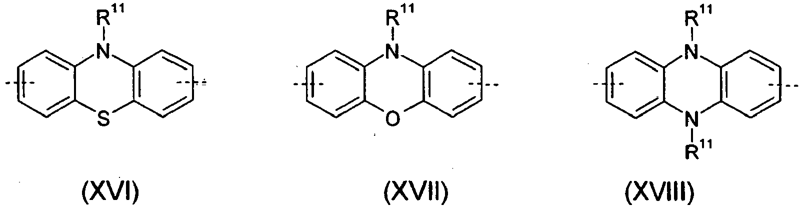 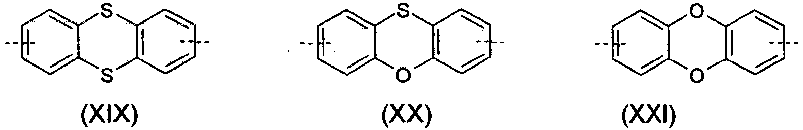 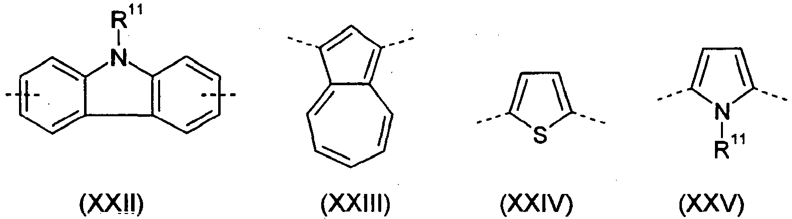 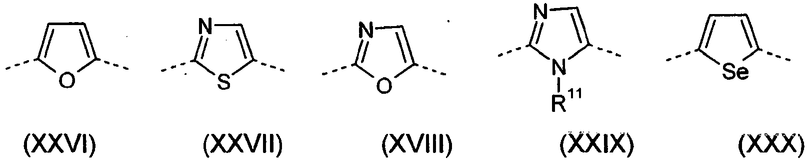 wobei R¹¹ eine der oben für R² angegebenen Bedeutungen besitzt, die verschiedenen Formeln an den freien Positionen auch zusätzlich durch einen oder mehrere Substituenten R¹¹ substituiert sein können und die Symbole und Indices folgendes bedeuten:
n ist gleich oder verschieden bei jedem Auftreten 0, 1 oder 2,
p ist gleich oder verschieden bei jedem Auftreten 0, 1 oder 2, vorzugsweise 0 oder 1,
o ist gleich oder verschieden bei jedem Auftreten 1, 2 oder 3, vorzugsweise 1 oder 2,
Ar¹¹, Ar¹³ sind bei jedem Auftreten gleich oder verschieden ein aromatisches oder heteroaromatisches Ringsystem mit 2 bis 40 C-Atomen, welches durch R¹¹ ein- oder mehrfach substituiert oder auch unsubstituiert sein kann; die möglichen Substituenten R¹¹ können dabei potentiell an jeder freien Position sitzen,
Ar¹², Ar¹⁴ sind bei jedem Auftreten gleich oder verschieden Ar¹¹, Ar¹³ oder eine substituierte oder unsubstituierte Stilbenylen- bzw. Tolanyleneinheit,
Ar¹⁵ ist gleich oder verschieden bei jedem Auftreten entweder ein System gemäß Ar¹¹ oder ein aromatisches oder heteroaromatisches Ringsystem mit 9 bis 40 aromatischen Atomen (C- oder Heteroatome), welches durch R¹¹ ein- oder mehrfach substituiert oder unsubstituiert sein kann und welches aus mindestens zwei kondensierten Ringen besteht; die möglichen Substituenten R¹¹ können dabei potentiell an jeder freien Position sitzen.

### Gruppe 3 - Struktureinheiten, welche die Elektroneninjektions- und/oder -transporteigenschaften der Polymere erhöhen:

Dies sind im Allgemeinen elektronenarme Aromaten oder Heterocyclen, wie z.B. substituierte oder unsubstituierte Pyridine, Pyrimidine, Pyridazine, Pyrazine, Pyrene, Perylene, Anthracene, Benzanthracene, Oxadiazole, Chinoline, Chinoxaline, Phenazine, Benzimidazole, Ketone, Phosphinoxide, Sulfoxide oder Triazine, aber auch Verbindungen wie Triarylborane und weitere O, S oder N-haltige Heterocyclen mit niedrig liegendem LUMO (LUMO = niedrigstes unbesetztes Molekülorbital), sowie Benzophenone und deren Derivate, wie z.B. in der WO 05/040302 offenbart.

Besonders bevorzugte Einheiten der Gruppe 3 sind zweibindige Einheiten gemäß den folgenden Formeln, worin die gestrichelten Linien die Verknüpfungen zu den benachbarten Einheiten bedeuten: 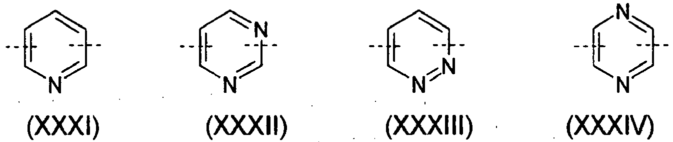 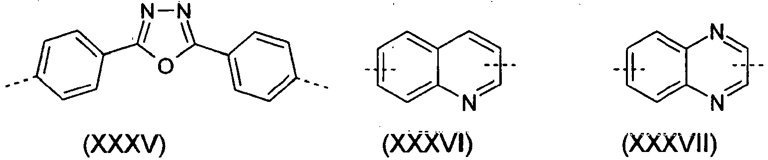 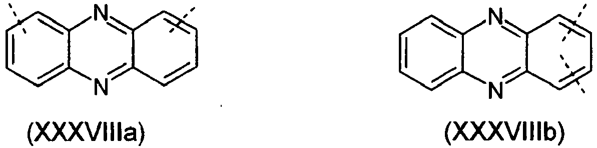 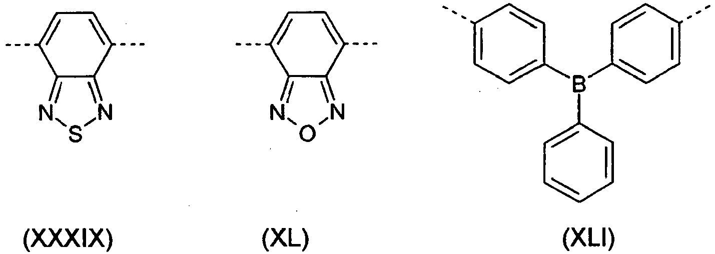 wobei die verschiedenen Formeln an den freien Positionen durch einen oder mehrere Substituenten R¹¹ wie oben definiert substituiert sein können.

### Gruppe 4 - Struktureinheiten, die Kombinationen von Einzeleinheiten der Gruppe 2 und Gruppe 3 aufweisen:

Es ist auch möglich, dass die Polymere Einheiten enthalten, in denen Strukturen, welche die Lochmobilität und welche die Elektronenmobilität erhöhen, direkt aneinander gebunden sind oder beides können. Allerdings verschieben einige dieser Einheiten die Emissionsfarbe ins Gelbe oder Rote. Ihre Verwendung in der erfindungsgemäßen optoelektronischen Vorrichtung zur Erzeugung blauer oder grüner Emission ist deshalb weniger bevorzugt.

Falls solche Einheiten der Gruppe 4 in den Polymeren enthalten sind, sind sie vorzugsweise ausgewählt aus zweibindigen Einheiten gemäß den folgenden Formeln, worin die gestrichelten Linien die Verknüpfungen zu den benachbarten Einheiten bedeuten: 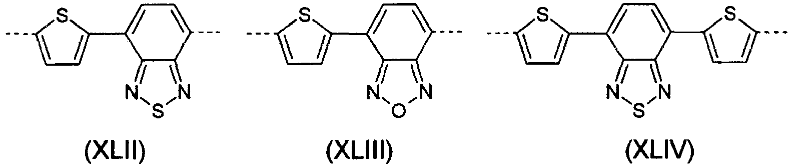 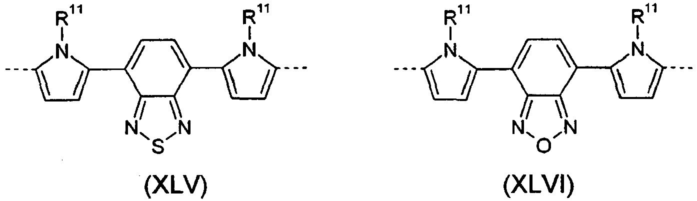 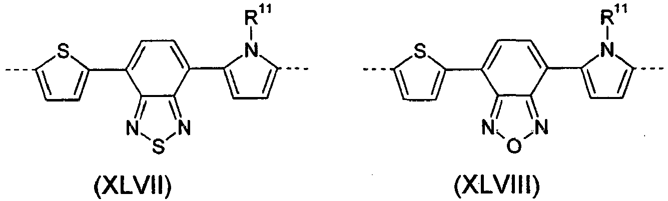 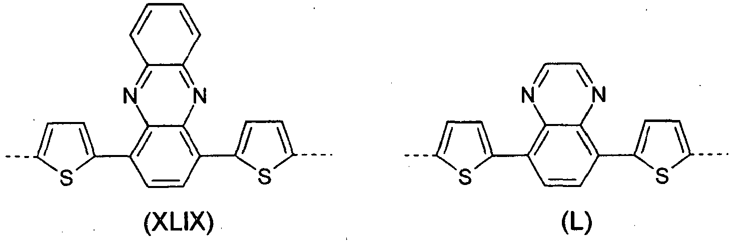 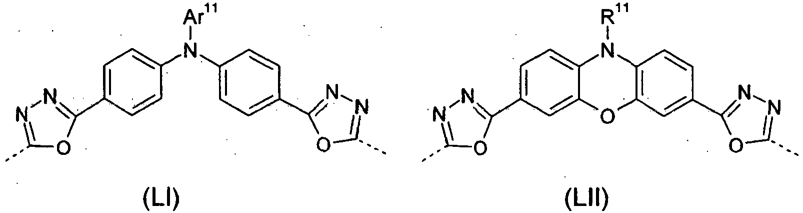 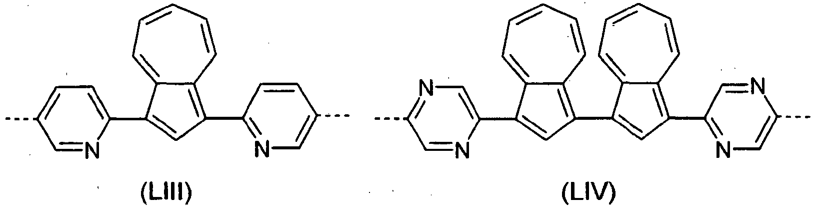 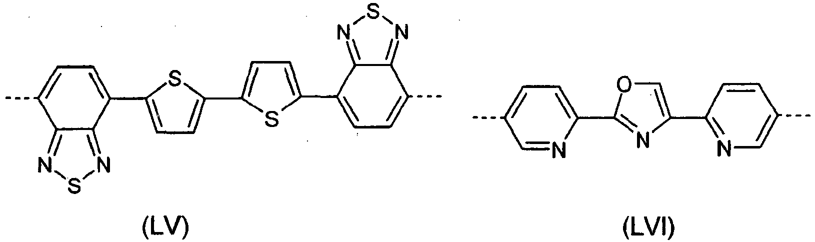 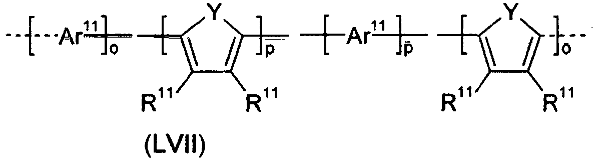 wobei die verschiedenen Formeln an den freien Positionen durch einen oder mehrere Substituenten R¹¹ substituiert sein können, die Symbole R¹¹, Ar¹¹, p und o die oben genannten Bedeutungen besitzen und Y bei jedem Auftreten gleich oder verschieden O, S, Se, N, P, Si oder Ge ist.

### Gruppe 5 - Struktureinheiten, welche die Morphologie und/oder die Emissionsfarbe der resultierenden Polymere beeinflussen:

Dies sind neben den oben genannten Einheiten solche, die mindestens noch eine weitere aromatische oder eine andere konjugierte Struktur aufweisen, welche nicht unter die o. g. Gruppen fällt, d.h. die die Ladungsträgermobilität nur wenig beeinflusst, die keine metallorganischen Komplexe sind oder die keinen Einfluss auf den Singulett-Triplett-Übergang haben. Derartige Strukturelemente können die Morphologie, aber auch die Emissionsfarbe der resultierenden Polymere beeinflussen. Je nach Einheit können sie daher auch als Emitter eingesetzt werden. Bevorzugt sind dabei substituierte oder unsubstituierte aromatische Strukturen mit 6 bis 40 C-Atomen oder auch Tolan-, Stilben- oder Bisstyrylarylenderivate, die jeweils mit einem oder mehreren Resten R¹¹ substituiert sein können. Besonders bevorzugt ist dabei der Einbau von 1,4-Phenylen-, 1,4-Naphthylen-, 1,4- oder 9,10-Anthrylen-, 1,6-, 2,7- oder 4,9-Pyrenylen-, 3,9- oder 3,10- Perylenylen-, 4,4'-Biphenylylen-, 4,4"-Terphenylylen-, 4,4'-Bi-1,1'-naphthylylen-, 4,4'-Tolanylen-, 4,4'-Stilbenylen- oder 4,4"-Bisstyrylarylenderivaten.

Ganz besonders bevorzugt sind substituierte oder unsubstituierte Strukturen gemäß den folgenden Formeln, worin die gestrichelten Linien die Verknüpfungen zu den benachbarten Einheiten bedeuten: 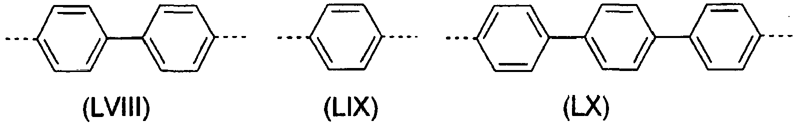 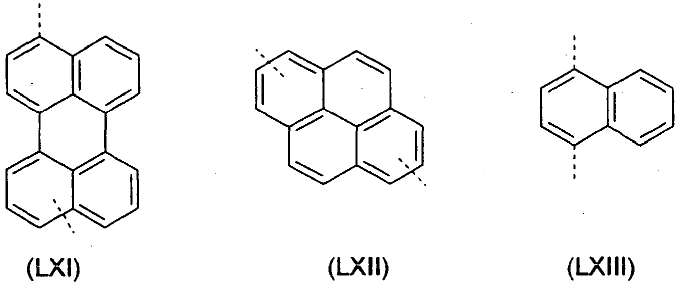 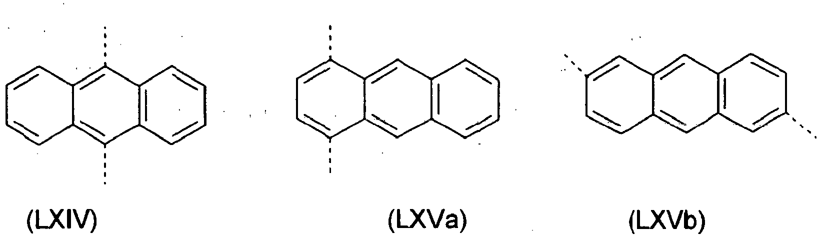 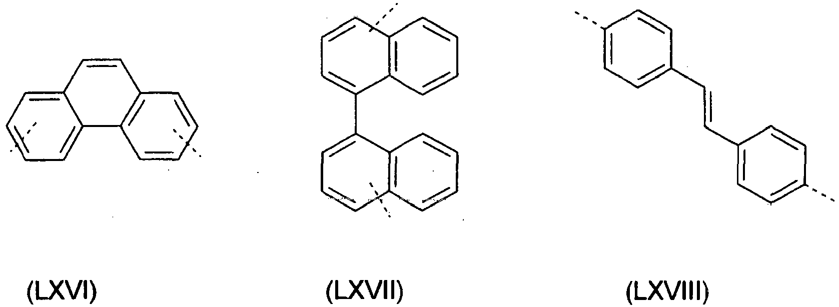 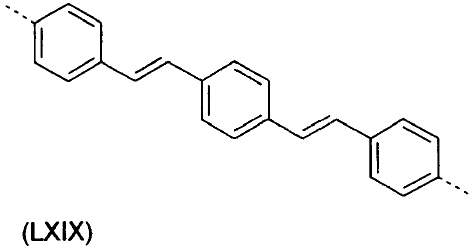 wobei die verschiedenen Formeln an den freien Positionen durch einen oder mehrere Substituenten R¹¹ wie oben definiert substituiert sein können.

### Gruppe 6 - Struktureinheiten, welche die Emissionscharakteristik insoweit verändern, dass Elektrophosphoreszenz statt Elektrofluoreszenz erhalten werden kann:

Dies sind insbesondere solche Einheiten, welche auch bei Raumtemperatur mit hoher Effizienz aus dem Triplettzustand Licht emittieren können, also Elektrophosphoreszenz statt Elektrofluoreszenz zeigen, was häufig eine Steigerung der Energieeffizienz bewirkt. Hierfür eignen sich zunächst Verbindungen, welche Schweratome mit einer Ordnungszahl von mehr als 36 enthalten. Besonders geeignet sind Verbindungen, welche d- oder f-Übergangsmetalle beinhalten, die die o. g. Bedingung erfüllen. Ganz besonders bevorzugt sind hier entsprechende Struktureinheiten, welche Elemente der Gruppe 8 bis 10 (Ru, Os, Rh, Ir, Pd, Pt) enthalten. Als Struktureinheiten für die Polymeren kommen hier z.B. verschiedene Komplexe in Frage, welche z.B. in der WO 02/068435, der WO 02/081488, der EP 1239526 und der WO 04/026886 beschrieben sind. Entsprechende Monomere sind in der WO 02/068435 und der WO 2005/042548 A1 beschrieben.

Bevorzugte Einheiten der Gruppe 6 sind solche der folgenden Formeln, worin die gestrichelten Linien die Verknüpfungen zu den benachbarten Einheiten bedeuten: 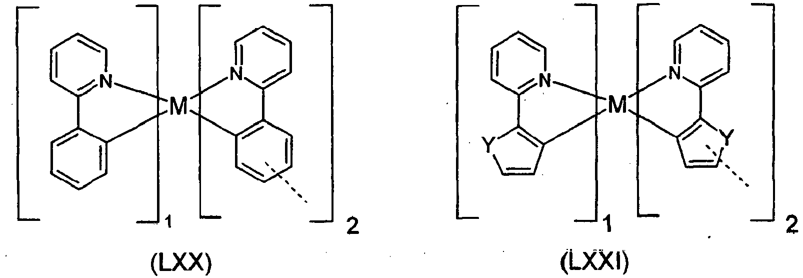 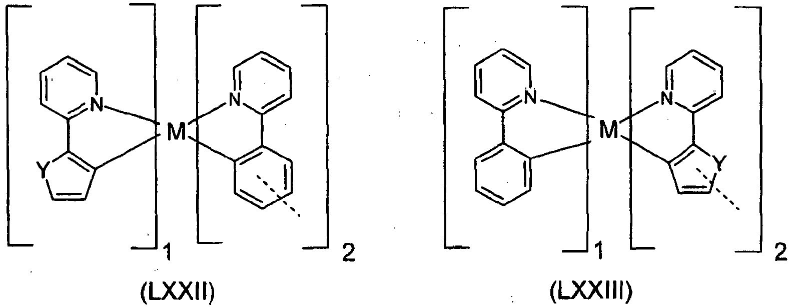 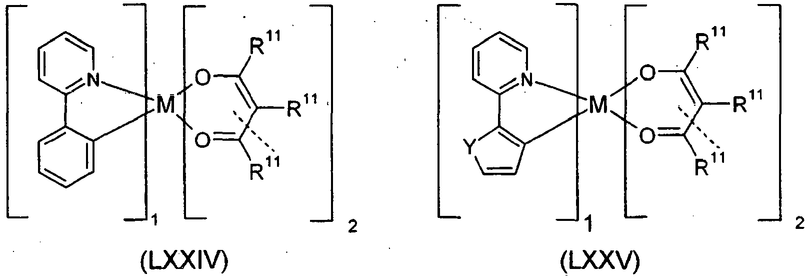 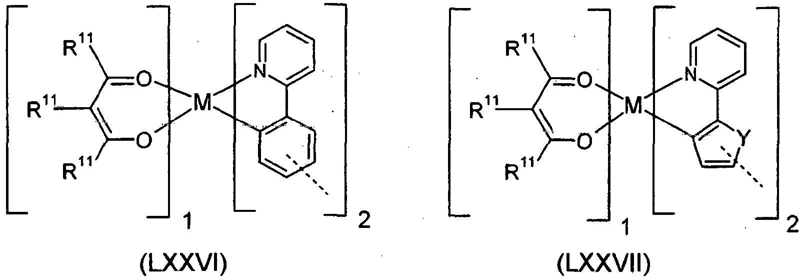 worin M für Rh oder Ir steht, Y die oben angegebene Bedeutung hat, und die verschiedenen Formeln an den freien Positionen durch eine oder mehrere Substituenten R¹¹ wie oben definiert substituiert sein können.

### Gruppe 7 - Struktureinheiten, welche den Übergang vom Singulett- zum Triplettzustand verbessern:

Dies sind insbesondere solche Einheiten, welche den Übergang vom Singulett- zum Triplettzustand verbessern und welche, unterstützend zu den Strukturelementen der Gruppe 6 eingesetzt, die Phosphoreszenzeigenschaften dieser Strukturelemente verbessern. Hierfür kommen insbesondere Carbazol- und überbrückte Carbazoldimereinheiten in Frage, wie z.B. in der WO 04/070772 und der WO 04/113468 beschrieben. Weiterhin kommen hierfür Ketone, Phosphinoxide, Sulfoxide und ähnliche Verbindungen in Frage, wie z.B. in der WO 2005/040302 A1 beschrieben.

Es ist auch möglich, dass gleichzeitig mehr als eine Struktureinheit aus einer der Gruppen 1 bis 7 vorliegt.

Das Polymer kann weiterhin ebenfalls in die Haupt- oder Seitenkette gebundene Metallkomplexe enthalten, die im Allgemeinen aus einem oder mehreren Liganden und einem oder mehreren Metallzentren aufgebaut sind.

Bevorzugt sind Polymere, die zusätzlich noch ein oder mehrere Einheiten ausgewählt aus den Gruppen 1 bis 7 enthalten.

Ebenfalls bevorzugt ist es, wenn die Polymere Einheiten enthalten, die den Ladungstransport oder die Ladungsinjektion verbessern, also Einheiten aus Gruppe 2 und/oder 3; besonders bevorzugt ist ein Anteil von 1 bis 30 mol% dieser Einheiten; ganz besonders bevorzugt ist ein Anteil von 2 bis 10 mol% dieser Einheiten.

Besonders bevorzugt ist es weiterhin, wenn die Polymere Einheiten aus Gruppe 1, Einheiten aus Gruppe 2 und/oder 3 und Einheiten aus Gruppe 5 enthalten.

Die Polymere weisen vorzugsweise 10 bis 10000, besonders bevorzugt 20 bis 5000 und insbesondere 50 bis 2000 Wiederholungseinheiten auf. Davon zu unterscheiden sind die erfindungsgemäßen fluorierten Oligomere, welche 3 bis 9 Wiederholungseinheiten aufweisen. Ansonsten können auch die Oligomere alle oben definierten Wiederholungseinheiten, auch die Emitter, besitzen.

Die nötige Löslichkeit der Polymere wird vor allem durch die Substituenten an den verschiedenen Wiederholungseinheiten gewährleistet.

Die Polymere können linear, verzweigt oder vernetzt sein. Die erfindungsgemäßen Copolymere können statistische, alternierende oder blockartige Strukturen aufweisen oder auch mehrere dieser Strukturen abwechselnd besitzen. Wie Copolymere mit blockartigen Strukturen erhalten werden können und welche weiteren Strukturelemente dafür besonders bevorzugt sind, ist beispielsweise ausführlich in der WO 2005/014688 beschrieben. Diese Schrift ist via Zitat Bestandteil der vorliegenden Anmeldung.

Die Polymere werden in der Regel durch Polymerisation von einer oder mehreren Monomersorten hergestellt. Geeignete Polymerisationsreaktionen sind dem Fachmann bekannt und in der Literatur beschrieben. Besonders geeignete und bevorzugte Polymerisations- und Kupplungsreaktionen, die alle zu C-C-Verknüpfungen führen, sind solche gemäß SUZUKI, YAMAMOTO, STILLE, HECK, NEGISHI, SONOGASHIRA oder HIYAMA.

Wie die Polymerisation nach diesen Methoden durchgeführt werden kann und wie die Polymere dann vom Reaktionsmedium abgetrennt und aufgereinigt werden können, ist dem Fachmann bekannt und in der Literatur, beispielsweise in der WO 2003/048225 und der WO 2004/037887, im Detail beschrieben.

Die C-C-Verknüpfungen sind bevorzugt ausgewählt aus den Gruppen der SUZUKI-Kupplung, der YAMAMOTO-Kupplung und der STILLE-Kupplung.

Zur Synthese der Polymere werden die entsprechenden Monomere benötigt. Die Synthese von Einheiten aus den Gruppen 1 bis 7 ist dem Fachmann bekannt und in der Literatur, beispielsweise in der WO 2005/014689, beschrieben. Diese und die darin zitierte Literatur ist via Zitat Bestandteil der vorliegenden Anmeldung.

Es kann außerdem bevorzugt sein, das Polymer nicht als Reinsubstanz, sondern als Mischung (Blend) zusammen mit weiteren beliebigen polymeren, oligomeren, dendritischen oder niedermolekularen Substanzen zu verwenden. Diese können beispielsweise die elektronischen Eigenschaften verbessern oder selber emittieren.

Wie Polymerlösungen oder Lösungen kleiner Moleküle hergestellt werden können, ist dem Fachmann bekannt und z.B. in der WO 02/072714, der WO 03/019694 und der darin zitierten Literatur beschrieben. Die Lösungen und Formulierungen können gegebenenfalls ein oder mehrere Additive enthalten.

Diese Lösungen können verwendet werden, um dünne Polymerschichten herzustellen, zum Beispiel durch Flächenbeschichtungsverfahren (z. B. Spin-coating) oder durch Druckverfahren (z.B. InkJet Printing).

Erfindungsgemäß wird als Elektrode Indium-Zinnoxid (ITO) oder Indium-Zinkoxid (IZO) verwendet. In diesem Fall werden die fluorhaltigen Gruppen nach dem Aufbringen der Elektrode auf das Substrat über eine Oberflächenreaktion oder CF₄-Plasmabehandlung auf die Elektrode aufgebracht. Dadurch entstehen auf der Oberfläche der Elektrode verschiedene fluorhaltige Gruppen, beispielsweise CF₃ oder sogar einzelne Fluoratome, die sich mit der ITO- bzw. IZO-Oberfläche verbinden.

Als Substrat wird erfindungsgemäß Glas oder eine Polymerfolie verwendet, bevorzugt ist Glas.

Erfindungsgemäß ist die Elektrode eine Zweischichtelektrode bestehend aus ITO/IZO und leitfähigem Polymer, und die fluorhaltigen Gruppen werden vor der Aufbringung der Elektrode auf das Substrat in das leitfähige Polymer eingebracht. Bevorzugt wird als leitfähiges Polymer eines der oben definierten konjugierten Polymere, PEDOT oder PANI verwendet, welche bevorzugt mit fluorhaltigen Gruppen versehen sind. Bei einem leitfähigen Polymer erfolgt die Fluorierung durch Methoden nach dem Stand der Technik, beispielsweise indem fluorierte Monomere polymerisiert werden oder indem das fertige Polymer fluoriert wird. Bevorzugt wird als fluorhaltige Gruppen enthaltende Komponente ein teilweise fluoriertes Polymer oder ein Polymer mit fluorierten oder perfluorierten Seitengruppen, ein Oligomer mit fluorierten Gruppen, ein fluoriertes Molekül, oder Kombinationen davon, eingesetzt. Besonders bevorzugt ist die Verwendung der dotierenden Spezies als Fluorträger (also z.B. fluorierte Polystyrolsulfonsäure).

Auf die aufgebrachte Schicht können nun eine oder mehrere zusätzliche Schichten aufgebracht werden, ohne dass die fixierte Schicht angelöst wird oder quillt. Die fluorhaltigen Gruppen der vorhergehenden Schicht und die fluorhaltigen Gruppen der aufgebrachten Schicht richten sich dabei so aus, dass eine adhäsive Fluor-Fluor-Wechselwirkung eintritt, welche nach Entfernen des Lösungsmittels eine so starke Adhäsion der aufgebrachten Schicht auf der vorhergehenden Schicht gewährleistet, dass ein besonders guter Kontakt ausgebildet wird. Auf diese Weise können mehrere Schichten mit guter Adhäsion abgeschieden werden, welche beispielsweise als Lochinjektionsschichten oder Elektronen-Sperrschichten fungieren, und diese Schichten können für die geeignete Farbe und Effizienz der Vorrichtung optimiert werden. Darüber hinaus kann die Lebensdauer einer derartigen Schicht durch eine verbesserte Elektronensperrfunktion erhöht werden (weniger Tunneleffekte in die darunter liegende Schicht, insbesondere bei PEDOT der Fall).

Nachdem alle zusätzlichen Schichten nacheinander aufgebracht wurden, folgt ferner das Aufbringen einer Kathode nach im Stand der Technik bekannten Methoden. Zuletzt folgt das Aufbringen einer Verkapselung, um die Vorrichtung vor äußeren Einflüssen wie Wasserdampf, Sauerstoff und dergleichen zu schützen.

Die Erfindung soll nun anhand einiger nicht als beschränkend auf den Umfang der Erfindung zu betrachtenden Ausführungsbeispiele unter Bezugnahme auf die Figuren näher erläutert werden.

Ausführungsbeispiele:

### Beispiel 1:

### Herstellung der erfindungsgemäßen Vorrichtung

### Schritt a) Modifikation der Indium-Zinnoxid Schicht

Vollflächiges ITO wurde vorgefertigt von Technoprint käuflich erworben. Die ITO Schichtdicke betrug 160 nm. Die ITO-Substrate wurden vorgereinigt (mit DI-Wasser und Deconex), getrocknet und in einen Plasmaofen transferiert. Dort wurde die ITO-Schicht durch eine CF₄-Plasmabehandlung (PS 400 Microwave Plasma System von PVA TePla America Inc., 0,4 mbar Druck, 200 ml/min CF₄-Fluß, 1000 Watt, 5 min) fluoriert.

Eine solche Fluorierung setzt im Allgemeinen die Oberflächenspannung des ITOs herab, was die Haftung einer weiteren abzuscheidenden Schicht erschweren sollte.

### Schritt b) Aufbringen einer Schicht eines leitfähigen fluorierten Polymers

Auf die modifizierte ITO Schicht wurde durch Spin-Coating aus wässriger Dispersion ein Film eines fluorierten Polyanilins (PANI) aufgebracht (PBM-001; Merck KGaA). Nach dem Aufbringen des Films wurde dieser bei 180°C für 10 Minuten ausgeheizt.

Es wurde ein homogener Film erhalten (Schichtdicke: 70 nm), der sich durch Behandlung mit Lösungsmitteln nicht wieder abwaschen ließ, also trotz der fluorierten ITO-Oberfläche sehr gut an ihr haftete. Dies ist auf die Fluor-Fluor-Wechselwirkung an der Grenzfläche zurückzuführen, die überraschend zu einer guten Haftung führt, was in einer daraus aufgebauten OLED zu einer verbesserten und homogeneren Ladungsinjektion von der Anode zum Polymer führt.

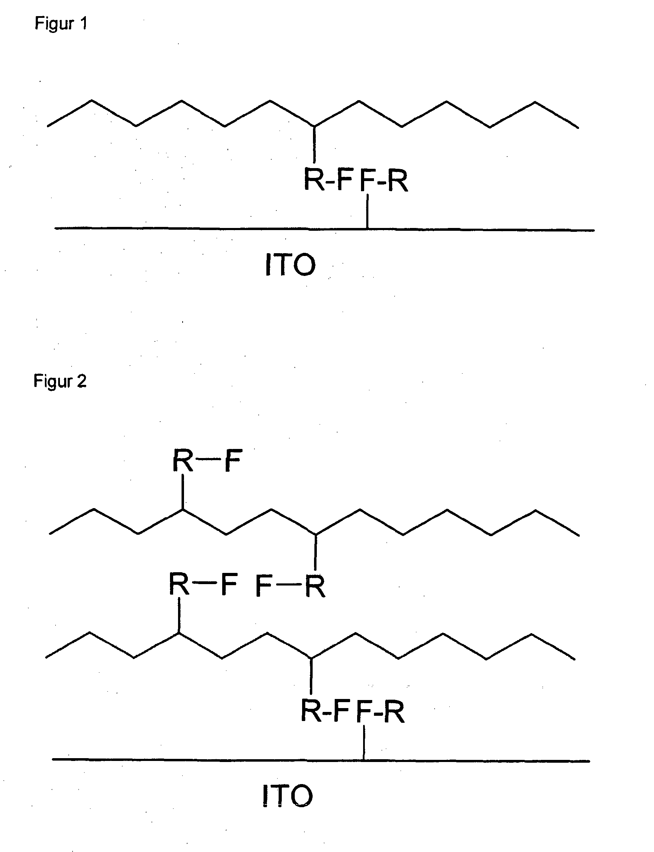

Figur 1 zeigt den erfindungsgemäßen Aufbau, bei dem eine fluorierte ITO-Schicht mit einem fluorierten Polymer beschichtet ist.

Anstelle des leitfähigen, fluorierten Polyanilins (PANI) können auch alle anderen leitfähigen Polymere (wie z.B. PEDOT/PSSH) eingesetzt werden, die entweder in fluorierter Form kommerziell erhältlich sind oder nach dem Fachmann bekannten Verfahren nachträglich fluoriert werden können.

Der in Schritt b) erhaltene Schichtaufbau wurde in Beispiel 2 weiter verwendet.

### Vergleichsbeispiel 2:

Die Modifikation der Indium-Zinnoxid Schicht (Schritt a) erfolgte wie in Beispiel 1.

### Schritt b) Aufbringen einer Schicht eines leitfähigen nicht-fluorierten Polymers

Auf die modifizierte ITO Schicht wurde durch Spin-Coating aus wässriger Dispersion ein Film eines nicht-fluorierten Polyanilins (PANI) aufgebracht (PAT020; Merck KGaA). Nach dem Aufbringen des Films wurde dieser bei 180°C für 10 Minuten ausgeheizt.

Es wurde kein geschlossener Film erhalten.

### Beispiel 3:

Der in Beispiel 1 erhaltene Schichtaufbau wurde mit einer weiteren Schicht eines fluorierten Polymers durch Spin-Coating beschichtet.

Als Polymer wurde dazu ein Polymer (P1) mit lochinjizierenden Eigenschaften verwendet, das unter Verwendung der folgenden Monomere (Prozentangaben = mol%) durch SUZUKI-Kupplung gemäß WO 03/048225 A2 synthetisiert wurde.

### Polymer P1:

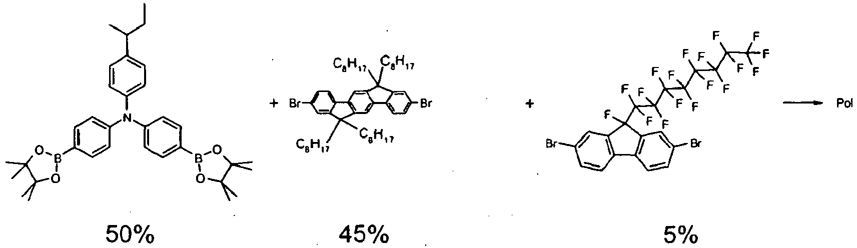

Figur 2 zeigt den erfindungsgemäßen Aufbau, bei dem der in Beispiel 1 hergestellte Schichtaufbau mit einer weiteren Schicht eines fluorierten Polymers durch Spin-Coating beschichtet ist.

### Vergleichsbeispiel 4:

Der in Beispiel 1 erhaltene Schichtaufbau wurde mit einer weiteren Schicht eines nicht-fluorierten Polymers durch Spin-Coating beschichtet.

Als Polymer wurde dazu ein Polymer (V1) mit lochinjizierenden Eigenschaften verwendet, das unter Verwendung der folgenden Monomere (Prozentangaben = mol%) analog Beispiel 3 synthetisiert wurde.

### Vergleichspolymer V1:

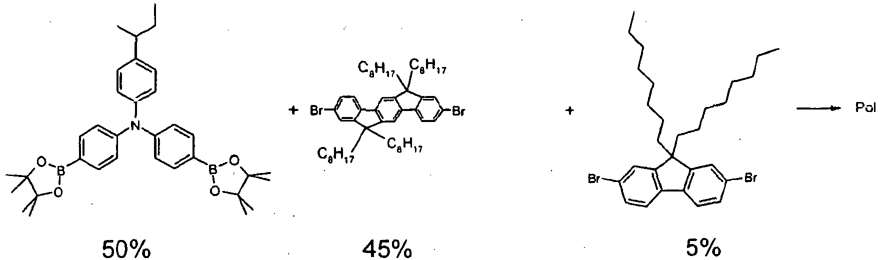

### Vergleichsbeispiel 5:

Der in Beispiel 1 erhaltene Schichtaufbau wurde mit einer weiteren Schicht eines nicht-fluorierten Polymers durch Spin-Coating beschichtet.

Als Polymer wurde dazu ein Polymer (V2) mit lochinjizierenden Eigenschaften verwendet, das unter Verwendung der folgenden Monomere (Prozentangaben = mol%) analog Beispiel 3 synthetisiert wurde.

### Vergleichspolymer V2:

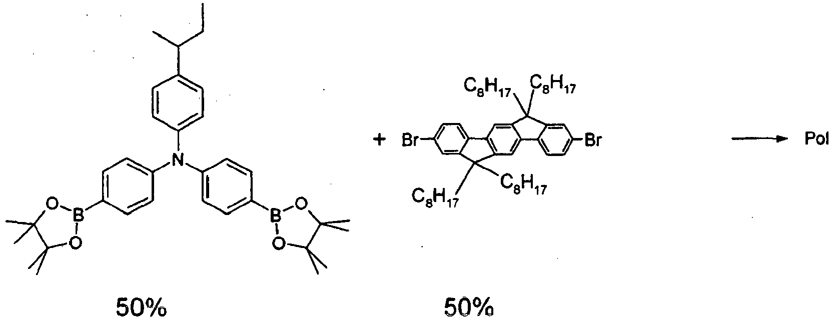

Um die Filmbildung und Haftung der Polymere zu untersuchen, wurden Fotos der mit P1, V1 und V2 aus Toluol (Konzentration 5 mg/ml) spingecoateten Filme gemacht (ausgeheizt für 10 Minuten bei 180°C) und die Schichtdicke gemessen. Als Substrat dienten jeweils die gemäß Beispiel 1 hergestellten Schichten. Um den Kontrast der Fotos zu verstärken, wurden die Filme unter eine UV-Lampe gelegt.

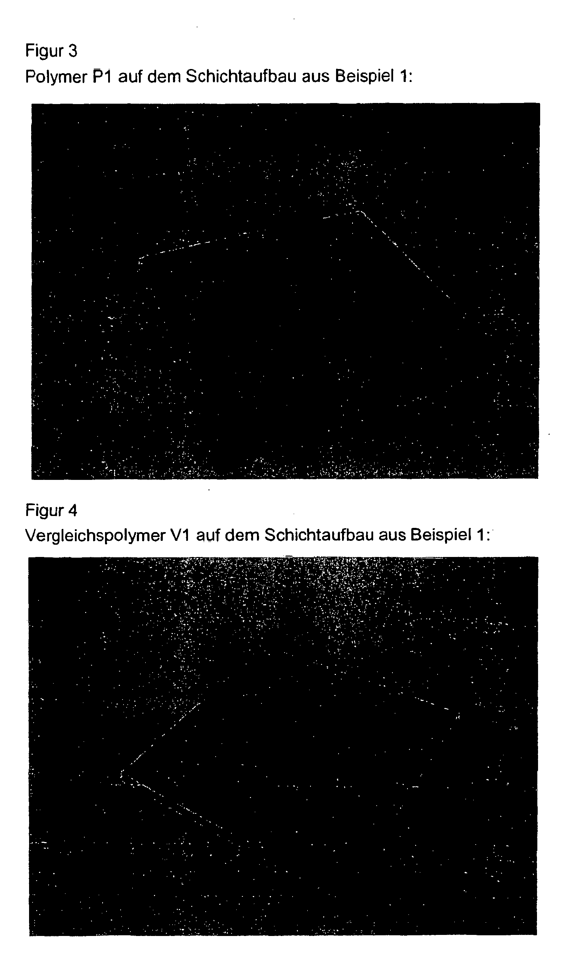

Für Polymer P1 wurde eine homogene, geschlossene Schicht von 15 nm Schichtdicke erhalten. Die oberste Schicht aus Beispiel 1 wurde dabei nicht angegriffen oder gequollen. Die Schichtdicken waren additiv und waren bei der Messung am Profilometer (Dektak ST3 von Veeco Instruments) als Stufen erkennbar (aus Beispiel 1: 70 nm, Schicht P1: 15 nm). Die Filmbildung des Polymeren P1 ist in Figur 3 abgebildet.

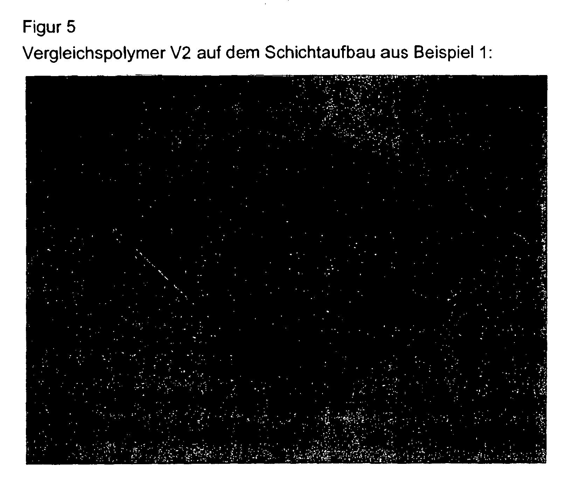

Im Falle der beiden nicht fluorierten Polymere V1 und V2 wurde trotz des eigentlich homogenisierenden Spincoatprozesses kein homogener Film erhalten. Schichtdickenmessungen sind daher hier nicht aussagekräftig. Die Filmbildung der Vergleichspolymere V1 und V2 ist in den Figuren 4 und 5 abgebildet.

Auf den Schichtaufbau aus Beispiel 2 können weitere Schichten aufgebracht werden. Diese Schichten können alle bekannten und geeigneten Materialien aufweisen und nach allen dem Fachmann bekannten Verfahren aufgebracht werden. Es ist dabei auch möglich, dass weitere Schichten mit fluorhaltigen Polymeren analog Beispiel 2 aufgebracht werden, die jeweils mit der vorherigen über die an der Oberfläche befindlichen Fluoratome wechselwirken können.

## Patentansprüche

1. Optoelektronische Vorrichtung umfassend auf einem Substrat eine erste Schicht, eine zweite Schicht und mindestens eine zusätzliche Schicht, **dadurch gekennzeichnet, dass** die erste Schicht eine Indium-Zinnoxid-Schicht (ITO) oder eine Indium-Zinkoxid-Schicht (IZO) mit fluorhaltigen Gruppen ist, dass die zweite Schicht eine Schicht eines leitfähigen Polymers mit fluorhaltigen Gruppen umfasst und dass die zusätzliche Schicht Verbindungen mit fluorhaltigen Gruppen umfasst, wobei zwischen einem Teil der fluorhaltigen Gruppen der ersten Schicht und der zweiten Schicht und zwischen einem Teil der fluorhaltigen Gruppen der zweiten Schicht und der zusätzlichen Schicht eine adhäsive Fluor-Fluor-Wechselwirkung besteht.

2. Optoelektronische Vorrichtung nach Anspruch 1, **dadurch gekennzeichnet, dass** die zusätzliche Schicht eine Ladungsinjektionsfunktion, eine Emitterfunktion, eine Barrierefunktion und/oder eine Kombination der genannten umfasst.

3. Optoelektronische Vorrichtung nach Anspruch 1 oder 2, **dadurch gekennzeichnet, dass** die Vorrichtung ein Polymer mit Emitterfunktion aufweist.

4. Optoelektronische Vorrichtung nach einem oder mehreren der Ansprüche 1 bis 3, **dadurch gekennzeichnet, dass** die Vorrichtung mehrere Schichten von Polymeren mit Emitterfunktion aufweist.

5. Optoelektronische Vorrichtung nach einem oder mehreren der Ansprüche 1 bis 4, **dadurch gekennzeichnet, dass** die Vorrichtung mehrere Schichten von Polymeren mit Lochleiterfunktion umfasst, wobei die Lochleiter energetisch unterschiedliche höchste besetzte Molekülorbitale (HOMO) aufweisen.

6. Optoelektronische Vorrichtung nach einem oder mehreren der Ansprüche 1 bis 5, **dadurch gekennzeichnet, dass** die Vorrichtung mehrere Schichten von Polymeren mit Elektronenleiterfunktion umfasst, wobei die Elektronenleiter energetisch unterschiedliche niedrigste unbesetzte Molekülorbitale (LUMO) aufweisen.

7. Verwendung einer optoelektronischen Vorrichtung nach einem oder mehreren der Ansprüche 1 bis 6 als organische oder polymere Leuchtdiode, als organische Solarzelle, als organischer FeldeffektTransistor, als organisches Schaltelement, als organisches Feld-Quench-Element, als organischer optischer Verstärker, als organische Laserdiode, als organischer Photorezeptor oder als organische Photodiode.

8. Verwendung nach Anspruch 7 als OLED in einem Display, in einem farbigen, mehrfarbigen oder vollfarbigen Display, als Beleuchtungselement oder als Backlight in einem Flüssigkristall-Display (LCD).

9. Verwendung nach Anspruch 8, **dadurch gekennzeichnet, dass** die OLED eine Weißlicht emittierende OLED ist.

## Claims

1. Opto-electronic device comprising a first layer, a second layer and at least one additional layer on a substrate, **characterised in that** the first layer is an indium tin oxide (ITO) layer or an indium zinc oxide (IZO) layer having fluorine-containing groups, **in that** the second layer comprises a layer of a conductive polymer having fluorine-containing groups and **in that** the additional layer comprises compounds having fluorine-containing groups, where an adhesive fluorine-fluorine interaction exists between some of the fluorine-containing groups of the first layer and the second layer and between some of the fluorine-containing groups of the second layer and the additional layer.

2. Opto-electronic device according to Claim 1, **characterised in that** the additional layer comprises a charge-injection function, an emitter function, a barrier function and/or a combination thereof.

3. Opto-electronic device according to Claim 1 or 2, **characterised in that** the device comprises a polymer having an emitter function.

4. Opto-electronic device according to one or more of Claims 1 to 3, **characterised in that** the device comprises a plurality of layers of polymers having an emitter function.

5. Opto-electronic device according to one or more of Claims 1 to 4, **characterised in that** the device comprises a plurality of layers of polymers having a hole-conductor function, where the hole conductors have energetically different highest occupied molecular orbitals (HOMO).

6. Opto-electronic device according to one or more of Claims 1 to 5, **characterised in that** the device comprises a plurality of layers of polymers having an electron-conductor function, where the electron conductors have energetically different lowest unoccupied molecular orbitals (LUMO).

7. Use of an opto-electronic device according to one or more of Claims 1 to 6 as organic or polymeric light-emitting diode, as organic solar cell, as organic field-effect transistor, as organic integrated circuit, as organic field-quench element, as organic optical amplifier, as organic laser diode, as organic photoreceptor or as organic photodiode.

8. Use according to Claim 7 as OLED in a display, in a coloured, multicoloured or full-colour display, as lighting element or as backlight in a liquid-crystal display (LCD).

9. Use according to Claim 8, **characterised in that** the OLED is an OLED which emits white light.

## Revendications

1. Dispositif opto-électronique comprenant une première couche, une seconde couche et au moins une couche additionnelle sur un substrat, **caractérisé en ce que** la première couche est une couche en oxyde d'indium et d'étain (ITO) ou une couche en oxyde d'indium et de zinc (IZO) comportant des groupes contenant du fluor, **en ce que** la seconde couche comprend une couche en un polymère conducteur comportant des groupes contenant du fluor et **en ce que** la couche additionnelle comprend des composés comportant des groupes contenant du fluor, où une interaction adhésive fluor-fluor existe entre certains des groupes contenant du fluor de la première couche et de la seconde couche et entre certains des groupes contenant du fluor de la seconde couche et de la couche additionnelle.

2. Dispositif opto-électronique selon la revendication 1, **caractérisé en ce que** la couche additionnelle comprend une fonction d'injection de charges, une fonction d'émetteur, une fonction de barrière et/ou une combinaison afférente.

3. Dispositif opto-électronique selon la revendication 1 ou 2, **caractérisé en ce que** le dispositif comprend un polymère présentant une fonction d'émetteur.

4. Dispositif opto-électronique selon une ou plusieurs des revendications 1 à 3, **caractérisé en ce que** le dispositif comprend une pluralité de couches en polymères présentant une fonction d'émetteur.

5. Dispositif opto-électronique selon une ou plusieurs des revendications 1 à 4, **caractérisé en ce que** le dispositif comprend une pluralité de couches en polymères présentant une fonction de conducteur de trous, où les conducteurs de trous présentent des orbites moléculaires occupées les plus hautes (HOMO) energétiquement différentes.

6. Dispositif opto-électronique selon une ou plusieurs des revendications 1 à 5, **caractérisé en ce que** le dispositif comprend une pluralité de couches en polymères présentant une fonction de conducteur d'électrons, où les conducteurs d'électrons présentent des orbites moléculaires non occupées les plus basses (LUMO) energétiquement différentes.

7. Utilisation d'un dispositif opto-électronique selon une ou plusieurs des revendications 1 à 6 en tant que diode émettrice de lumière organique ou polymérique, en tant que cellule solaire organique, en tant que transistor à effet de champ organique, en tant que circuit intégré organique, en tant qu'élément à extinction de champ organique, en tant qu'amplificateur optique organique, en tant que diode laser organique, en tant que photorécepteur organique ou en tant que photodiode organique.

8. Utilisation selon la revendication 7 en tant qu'OLED dans un affichage, dans un affichage couleur, multicouleur ou pleine couleur, en tant qu'élément d'éclairage ou en tant que lumière arrière dans un affichage à cristaux liquides (LCD).

9. Utilisation selon la revendication 8, **caractérisée en ce que** l'OLED est une OLED qui émet une lumière blanche.
